# EUROPÄISCHE PATENTSCHRIFT

(11) **EP 2 001 038 B1**
(45) Veröffentlichungstag und Bekanntmachung des Hinweises auf die Patenterteilung: **10.08.2016**
(21) Anmeldenummer: 08157672.0
(22) Anmeldetag: 05.06.2008
(51) Int. Cl.: H01J 37/20, H01J 37/26, H01J 37/305

(54) **Teilchenstrahlgerät und Verfahren zur Anwendung bei einem Teilchenstrahlgerät**
Charged particle beam device and method applied in a charged particle beam device
Appareil de faisceau de particules chargées et procédé utilisé dans un appareil de faisceau de particules chargées

(30) Priorität: 06.06.2007 DE 102007026847
(43) Veröffentlichungstag der Anmeldung: 10.12.2008
(73) Patentinhaber: Carl Zeiss Microscopy GmbH, 07745 Jena (DE)
(72) Erfinder: Zeile, Ulrike, 89522 Heidenheim (DE); Schertel, Andreas, 73431 Aalen (DE)
(74) Vertreter: Freischem & Partner Patentanwälte mbB

(56) Entgegenhaltungen:
- EP-A1- 0 927 880
- EP-A2- 1 998 356
- JP-A- 2001 311 681
- JP-A- 2004 340 611
- US-A1- 2005 199 828
- HENDRIK O. COLIJN: 'The DualBeam FIB in a Materials Science Laboratory' MICROSC. MICROANAL. Bd. 8 (SUPPL. 2), 01 Januar 2002, Seiten 58 - 59, XP055074449

## Beschreibung

Die Erfindung betrifft ein Teilchenstrahlgerät und ein Verfahren zur Anwendung bei einem Teilchenstrahlgerät, bei denen eine Probe auf einem Trägerelement angeordnet ist. Die Erfindung betrifft auch ein Trägerelement mit einem Probenaufnahmeelement.

Teilchenstrahlgeräte, beispielsweise Elektronenstrahlgeräte, werden zur Untersuchung von Objekten (Proben) seit langem verwendet. Bekannt sind insbesondere Rasterelektronenmikroskope und Transmissionselektronenmikroskope. Bei einem Rasterelektronenmikroskop wird ein mittels eines Strahlerzeugers erzeugter Elektronenstrahl durch eine Objektivlinse auf das zu untersuchende Objekt fokussiert. Mittels einer Ablenkvorrichtung wird der Elektronenstrahl (nachfolgend auch Primärelektronenstrahl genannt) rasterförmig über die Oberfläche des zu untersuchenden Objekts geführt. Die Elektronen des Primärelektronenstrahls treten dabei in Wechselwirkung mit dem Objekt. Als Folge der Wechselwirkung werden insbesondere Elektronen aus dem Objekt emittiert (sogenannte Sekundärelektronen) oder Elektronen des Primärelektronenstrahls zurückgestreut (sogenannte Rückstreuelektronen). Sekundär- und Rückstreuelektronen bilden den sogenannten Sekundärstrahl und werden mit einem Detektor detektiert. Das hierdurch erzeugte Detektorsignal wird zur Bilderzeugung verwendet.

Ferner ist es bekannt, ein Rasterelektronenmikroskop mit einer Ionensäule auszustatten. Mittels eines in der Ionensäule angeordneten Ionenstrahlerzeugers werden Ionen erzeugt, die zur Präparation von Objekten (beispielsweise Polieren eines Objekts oder Aufbringen von Material auf ein Objekt) oder aber auch zur Bildgebung verwendet werden.

Eine weitere bekannte Vorrichtung zur Präparation eines Objekts (Probe) in einem Teilchenstrahlgerät mittels eines Teilchenstrahls wird nachfolgend beschrieben. Mit dieser weiteren bekannten Vorrichtung wird von einer ersten Probe, die in einer Vakuumkammer auf einem Probentisch angeordnet ist, eine zweite Probe extrahiert und an einem Probenhalter befestigt, der ebenfalls an dem Probentisch angeordnet ist. Der Probenhalter wird zur weiteren Untersuchung der zweiten Probe aus der Vakuumkammer geschleust. Dies ist bei manchen Anwendungen von Nachteil, weil die Ausschleusung des Probenhalters zum einen sehr viel Zeit benötigt und zum anderen die Gefahr besteht, daß die zweite Probe kontaminiert werden könnte.

Desweiteren ist aus dem Stand der Technik eine Vorrichtung bzw. ein Verfahren zur Probenpräparation mit den folgenden Merkmalen bzw. Verfahrenschritten bekannt. In einem Teilchenstrahlgerät wird in einer Vakuumkammer auf einem Probentisch eines Manipulators eine Probe angeordnet. In einer ersten Position des Manipulators wird mittels eines Ionenstrahls ein Stück aus der Probe geschnitten und dieses herausgeschnittene Stück an einem Probenhalter befestigt, der an dem Manipulator angeordnet ist. Der Manipulator wird durch eine lineare Bewegung in eine zweite Position gebracht, in der nun ein Elektronenstrahl auf dieses Stück zur weiteren Untersuchung fokussiert wird. Durch dieses Stück hindurchtretende Elektronen werden mittels eines Detektors detektiert. Von Nachteil ist bei dieser bekannten Vorrichtung jedoch, daß diese recht komplex aufgebaut ist. Hinsichtlich des oben genannten Standes der Technik wird auf die DE 103 51 276 A1, die US 6,963,068 sowie die EP 0 927 880 A1 verwiesen.

JP2001311681 offenbart eine Methode zur Präparation einer Probe zur transmissionselektronenmikroskopischen Beobachtung und einen Apparat zum Entnehmen einer Probe.

JP200434031 offenbart ein Gerät und eine Methode zur Herstelung dünner Proben.

Us2005/0199828 offenbart eine MEthode und einen Apparat zur Herstellung einer Mikroprobe.

EP1998356 A2 fällt unter Art. 54 (3) und ist für die Frage der erfinderischen Tätigkeit nicht von Bedeutung. Es offenbart eine In-Situ STEM Probenpräparation.

Der Erfindung liegt daher die Aufgabe zugrunde, ein Teilchenstrahlgerät ein Trägerelement mit einem Aufnahmeelement sowie ein in dem Teilchenstrahlgerät anwendbares Verfahren zur Probenpräparation und/oder Probenuntersuchung anzugeben, wobei die Vorrichtung einfach aufgebaut ist und wobei das Verfahren nicht sehr zeitaufwendig ist.

Erfindungsgemäß wird diese Aufgabe durch ein Teilchenstrahlgerät mit den Merkmalen des Anspruchs 1 gelöst. Ein erfindungsgemäßes Verfahren wird durch die Verfahrenschritte des Anspruchs 6 bestimmt. Bevorzugte Ausführungsbeispiele und weitere Merkmale der Erfindung ergeben sich aus den weiteren Ansprüchen, der weiteren Beschreibung und/oder den beigefügten Figuren.

Die Erfindung geht insbesondere von dem Gedanken aus, daß bereits in einem Teilchenstrahlgerät vorhandene Bauteile, insbesondere ein als Trägerelement ausgebildeter und beweglich angeordneter Probentisch zur Vereinfachung einer Vorrichtung zur Probenuntersuchung und/oder Probenpräparation nutzbar ist. Bei erfindungsgemäßen Teilchenstrahlgeräten muß eine Probe zur weiteren Untersuchung aus einer Vakuumkammer nicht ausgeschleust werden. Bei der Anordnung von zwei Aufnahmeelementen ist es möglich, aus einer ersten Probe eine zweite Probe zu extrahieren, die zweite Probe zu präparieren und zu untersuchen, ohne daß die zweite Probe aus einer Vakuumkammer ausgeschleust werden muß. Ferner sind aufgrund der Anordnung der beiden Aufnahmeelemente an dem Trägerelement einfache und gut steuerbare Bewegungsabläufe möglich. Der gesamte zuvor beschriebene Prozess ist vollautomatisch mittels einer geeigneten Steuerung ausführbar. Dies gilt ebenfalls für das nicht erfindungsgemäße Teilchenstrahlgerät, bei dem durch das Lösen und anschließendem Wiederverbinden des Aufnahmeelements das Aufnahmeelement in eine Stellung bringbar ist, in der eine Probe mittels eines Teilchenstrahls bestrahlbar ist. Die Erfindung weist auch den Vorteil auf, daß die Aufnahmeelemente keine Bewegungsmechaniken aufweisen müssen, da sämtliche notwendigen Bewegungen über die Bewegungsfreiheitsgrade des Trägerelements (beispielsweise ein Probentisch) realisierbar sind. Das Trägerelement mit den Aufnahmeelementen eignet sich auch besonders gut zum Ausschleusen einer Probe aus dem Teilchenstrahlgerät (beispielsweise einer in dem Teilchenstrahlgerät präparierten Probe). Zusätzlich oder alternativ hierzu eignet sich das Trägerelement mit den Aufnahmeelementen besonders gut zum Einschleusen einer vorpräparierten Probe in das Teilchenstrahlgerät.

Bei einer nicht erfindungsgemäßen Ausgestaltung des Teilchenstrahlgeräts, bei dem das Aufnahmeelement durch Lösen vom Trägerelement und anschließendem Verbinden mit dem Trägerelement positioniert wird, ist das Aufnahmeelement durch Lösen vom Trägerelement von einer ersten Stellung und anschließendem Verbinden mit dem Trägerelement in eine zweite Stellung bringbar. Ferner weist das Aufnahmeelement eine Aufnahmeachse auf, wobei die Aufnahmeachse in der ersten Stellung und die Aufnahmeachse in der zweiten Stellung um einen Winkel zueinander versetzt angeordnet sind. Vorzugsweise liegt dieser Winkel in einem Bereich von 20° bis 160°, besonders bevorzugt bei 90°.

Bei einer weiteren Ausgestaltung eines solchen nicht erfindungsgemäßen Teilchenstrahlgeräts, bei dem das Aufnahmeelement durch Lösen vom Trägerelement und anschließendem Verbinden mit dem Trägerelement in eine Stellung derart bringbar ist, in der eine Probe mittels eines Teilchenstrahls bestrahlbar ist, ist das Trägerelement vorzugsweise in drei zueinander senkrecht angeordnete Raumrichtungen beweglich ausgebildet. Ferner ist es um eine erste Achse, die parallel zur optischen Achse angeordnet ist oder der optischen Achse entspricht, sowie um eine zweite Achse, die senkrecht zur optischen Achse angeordnet ist, drehbar ausgebildet.
Bei dem vorgenannten erfindungsgemäßen Teilchenstrahlgerät weist in einer besonderen Ausführungsform das Trägerelement mindestens ein erstes Führungselement und das Aufnahmeelement mindestens ein zweites Führungselement auf, wobei das erste Führungselement und das zweite Führungselement zueinander komplementär ausgebildet sind. Beispielsweise ist das erste Führungselement als schwalbenschwanzförmiger Vorsprung ausgebildet, während das zweite Führungselement als entsprechend komplementär ausgebildete Ausnehmung ausgebildet ist. Bei einer weiteren Ausführungsform sind das zweite Führungselement als schwalbenschwanzförmiger Vorsprung und das erste Führungselement als entsprechend komplementär ausgebildete Ausnehmung ausgebildet. Die Offenbarung insgesamt jedoch ist durchaus nicht auf ein einzelnes erstes Führungselement oder ein einzelnes zweites Führungselement eingeschränkt. Vielmehr sind durchaus nicht erfindungsgemäße Ausgestaltungen vorgesehen, die mehr als ein einzelnes erstes Führungselement und mehr als ein einzelnes zweites Führungselement aufweisen. Die vorgenannten Führungselemente dienen der Anordnung des Aufnahmeelements an der ersten oder zweiten Stellung und gewährleisten demnach die winkelversetzte Anordnung, welche oben beschrieben wurde.

Bei nicht erfindungsgemäßen Ausgestaltungen des vorgenannten Teilchenstrahlgeräts weist das Aufnahmeelement eine Bewegungsvorrichtung derart auf, daß das Aufnahmeelement mittels dieser Bewegungsvorrichtung in die mindestens eine Stellung bringbar ist, in der eine Probe mittels eines Teilchenstrahls bestrahlbar ist. Die Bewegungsvorrichtung ist vorzugsweise als eine mechanisch angetriebene und/oder elektrisch angetriebene Vorrichtung ausgebildet. Beispielsweise ist die Bewegungsvorrichtung als eine Aufnahme, insbesondere eine Gewindeaufnahme, zur Anordnung eines Manipulatorstabs ausgebildet. Mittels des Manipulatorstabs ist es dann möglich, das Aufnahmeelement von dem Trägerelement zu lösen, es anschließend wieder mit dem Trägerelement zu verbinden und dabei das Aufnahmeelement in eine Stellung derart zu bringen, daß eine Probe mittels eines Teilchenstrahls bestrahlbar ist.

Die Bewegungsvorrichtung kann auch automatisch steuerbar ausgebildet sein. Für diese Ausführungsform sind mindestens eine Steuereinheit und zumindest ein elektrischer Antrieb vorgesehen.

Bei einer weiteren Ausführungsform ist die Bewegungsvorrichtung als Manipulatorstab und in besonderen Fällen als Wobbelstab ausgebildet.

Sämtliche obengenannten Ausführungsformen des erfindungsgemäßen Teilchenstrahlgeräts weisen mindestens einen Detektor auf, mit dem durch die Probe oder eine der Proben transmittierte Teilchen oder in Ausbreitungsrichtung eines Teilchenstrahls aus der Probe oder einer der Proben austretende gestreute Teilchen detektiert werden. Ein hierzu geeignetes Detektorsystem ist beispielsweise aus der WO 2005/006384 bekannt.

Sämtliche obengenannten Ausführungsformen des erfindungsgemäßen Teilchenstrahlgeräts weisen vorzugsweise mindestens einen Detektor zur Detektion von Teilchen auf, die von einer Probe oder mehreren Proben emittiert werden.

Ein besonderes Ausführungsbeispiel der obengenannten Teilchenstrahlgeräte weist mindestens einen Strahlerzeuger zur Erzeugung eines Teilchenstrahls sowie mindestens ein Strahlführungssystem zur Führung eines Teilchenstrahls in dem Teilchenstrahlgerät auf. Der zuvor genannte Detektor ist dabei vorzugsweise vom Strahlerzeuger in Richtung des Trägerelements aus gesehen hinter dem Trägerelement angeordnet (also beispielsweise der aus der WO 2005/006384 bekannte Detektor). Ferner ist vorzugsweise vorgesehen, daß das Teilchenstrahlgerät mindestens eine Objektivlinse zur Fokussierung eines Teilchenstrahls auf eine Probe aufweist.

Bei einem weiteren Ausführungsbeispiel ist das Teilchenstrahlgerät mit mindestens einer Vakuumkammer versehen, an der die Teilchenstrahlsäule angeordnet ist und in der das Trägerelement angeordnet ist.
Alle Ausführungsbeispiele des erfindungsgemäßen Teilchenstrahlgeräts sind mit mehreren Teilchenstrahlsäulen ausgebildet. Die erste optische Achse und die zweite optische Achse schließen einen Winkel ein. Dieser Winkel liegt bevorzugt in einem Bereich von 20° bis 90°. Bevorzugt weist die erste Teilchenstrahlsäule den oben genannten Strahlerzeuger in Form eines ersten Strahlerzeugers zur Erzeugung eines ersten Teilchenstrahls und das oben genannte Strahlführungssystem in Form eines ersten Strahlführungssystems zur Führung eines ersten Teilchenstrahls auf. Die zweite Teilchenstrahlsäule hingegen weist mindestens einen zweiten Strahlerzeuger zur Erzeugung eines zweiten Teilchenstrahls sowie mindestens ein zweites Strahlführungssystem zur Führung eines zweiten Teilchenstrahls in der zweiten Teilchenstrahlsäule auf. Beispielsweise dient ein erster Teilchenstrahl der ersten Teilchenstrahlsäule der Beobachtung und Untersuchung einer Probe, während ein zweiter Teilchenstrahl der zweiten Teilchenstrahlsäule der Präparation der Probe dient.

Vorzugsweise ist zusätzlich vorgesehen, daß die oben genannte Objektivlinse der ersten Teilchenstrahlsäule als eine erste Objektivlinse zur Fokussierung eines ersten Teilchenstrahls auf eine Probe ausgebildet ist und daß die zweite Teilchenstrahlsäule eine zweite Objektivlinse zur Fokussierung eines zweiten Teilchenstrahls auf eine Probe aufweist.

Bei einer bevorzugten Ausführungsform der Erfindung ist die erste Teilchenstrahlsäule als Elektronensäule und die zweite Teilchenstrahlsäule als Ionensäule ausgebildet. Insbesondere ist es vorgesehen, mittels eines Elektronenstrahls eine Probe zu untersuchen und mittels eines Ionenstrahls zu präparieren.

Desweiteren ist bei einer Ausführungsform der Erfindung vorgesehen, daß das Trägerelement um die erste Achse bis zu maximal 360°, vorzugsweise bis zu maximal 300° und noch bevorzugter bis zu maximal 240° drehbar ausgebildet ist. Eine weitere bevorzugte Ausführungsform sieht vor, daß das Trägerelement um die erste Achse bis zu maximal 180° drehbar ausgebildet ist.

Eine weitere Ausführungsform der Erfindung ist derart ausgestaltet, daß das Trägerelement um die zweite Achse bis zu maximal 90°, vorzugsweise maximal bis 60° und noch bevorzugter bis zu maximal 45° drehbar ausgebildet ist. Bei einer weiteren Ausführungsform ist das Trägerelement um bis zu maximal 30° um die zweite Achse drehbar ausgebildet.

Aufgrund der besonderen Ausbildung des Trägerelements und der Aufnahmeelemente bzw. des Aufnahmeelements gewährleistet die Erfindung trotz möglicher Beschränkung der Bewegungsfreiheit des Trägerelements (beispielsweise ein Probentisch) eine ausreichende Bewegungsfreiheit.

Die Erfindung betrifft auch ein Elektronenmikroskop, insbesondere ein Rasterelektronenmikroskop oder ein Transmissionselektronenmikroskop, das als Teilchenstrahlgerät nach Anspruch 1 ausgebildet ist, welches eines der oben genannten Merkmale oder eine Kombination von oben genannten Merkmalen aufweist.

Der nicht als die Erfindung beanspruchte Teil der Offenbarung betrifft auch ein System zur Aufnahme einer oder mehrerer Proben, das mindestens ein Trägerelement und Aufnahmeelemente aufweist. Das Trägerelement ist in drei zueinander senkrecht angeordneten Raumrichtungen beweglich ausgebildet und um eine erste Achse sowie um eine zweite Achse, die senkrecht zur ersten Achse angeordnet ist, drehbar. Ferner sind mindestens ein eine erste Aufnahmeachse aufweisendes erstes Aufnahmeelement zur Aufnahme einer ersten Probe und mindestens ein eine zweite Aufnahmeachse aufweisendes zweites Aufnahmeelement zur Aufnahme einer zweiten Probe vorgesehen, wobei die erste Aufnahmeachse und die zweite Aufnahmeachse um einen Winkel im Bereich von 10° bis 90° zueinander versetzt angeordnet sind. Bevorzugt ist ein Bereich von 20° bis 90°. Bei einem solchen Beispiel weist das erste Aufnahmeelement eine erste Aufnahmefläche auf, deren Flächennormalen der ersten Aufnahmeachse entspricht. Entsprechendes gilt für das zweite Aufnahmeelement. Dieses weist eine zweite Aufnahmefläche auf, deren Flächennormalen der zweiten Aufnahmeachse entspricht. Die Offenbarung ist aber nicht auf diese Definition eingeschränkt. Beispielsweise kann das erste Aufnahmeelement auch eine erste Aufnahmefläche aufweisen, die in einer ersten Ebene, in der die erste
Aufnahmeachse liegt, angeordnet ist, während das zweite Aufnahmeelement eine zweite Aufnahmefläche aufweist, die in einer zweiten Ebene angeordnet ist, in der die zweite Aufnahmeachse liegt. Die erste Ebene und die zweite Ebene sind dann zueinander um einen Winkel von 10° bis 90° versetzt angeordnet. Es sind aber auch andere Definitionen denkbar. Beispielsweise können auch eine Längsachse des zweiten Aufnahmeelements und eine Flächennormale des ersten Aufnahmeelements den vorgenannten Winkel einschließen.

Der nicht als Erfindung beanspruchte Teil der Offenbarung betrifft auch ein System mit mindestens einem Trägerelement und mindestens einem Aufnahmeelement zur Aufnahme einer Probe, wobei das Aufnahmeelement lösbar mit dem Trägerelement verbunden ist und eine Aufnahmeachse aufweist. Vorzugsweise ist die Aufnahmeachse eine Flächennormalen einer Aufnahmefläche des Aufnahmeelements. Das Aufnahmeelement ist durch Lösen vom Trägerelement aus mindestens einer ersten Stellung und anschließendem Verbinden mit dem Trägerelement in mindestens eine zweite Stellung bringbar, wobei die Aufnahmeachse in der ersten Stellung und die Aufnahmeachse in der zweiten Stellung unter einem Winkel im Bereich von 20° bis 160° zueinander angeordnet sind. Bei dieser Ausführungsform ist vorzugsweise vorgesehen, daß das Trägerelement in drei zueinander senkrecht angeordneten Raumrichtungen beweglich ausgebildet ist und um eine erste Achse sowie um eine zweite Achse, die senkrecht zur ersten Achse angeordnet ist, drehbar ist.

Die vorgenannten Systeme gemäß dem nicht als Erfindung beanspruchten Teil der Offenbarung sind insbesondere zum Einsatz in dem Teilchenstrahlgerät, das bereits weiter oben mit seinen einzelnen Merkmalen und Merkmalskombinationen beschrieben wurde, vorgesehen und sind für dieses Teilchenstrahlgerät gedacht. Die Systeme weisen dieselben Vorteile auf, die bereits oben genannt wurden oder weiter unten noch genannt werden. Insbesondere ist aufgrund der Ausbildung des Trägerelements und der Aufnahmeelemente bzw. des Aufnahmeelements trotz möglicher Beschränkung der Bewegungsfreiheit des Trägerelements (beispielsweise ein Probentisch) eine ausreichende Bewegungsfreiheit gewährleistet.
Bevorzugt weisen die oben genannten Systeme einen Winkel zwischen den Achsen im Bereich von 30° bis 90° auf, beispielsweise 54° oder 90°.

Bei einer besonderen Ausgestaltung der Systeme ist das Trägerelement um die erste Achse bis zu maximal 360°, vorzugsweise bis zu maximal 300° und ganz bevorzugt bis zu maximal 240° drehbar ausgebildet. Bei einer weiteren Ausgestaltung ist das Trägerelement um die erste Achse bis zu maximal 180° drehbar ausgebildet.

Bei einer weiteren Ausgestaltung der Systeme ist das Trägerelement um die zweite Achse bis zu maximal 90°, vorzugsweise bis zu maximal 60° und besonders bevorzugt bis zu maximal 45° drehbar ausgebildet. Bei einer weiteren Ausgestaltung ist das Trägerelement um die zweite Achse bis zu maximal 30° drehbar ausgebildet.

Die Erfindung betrifft auch ein Verfahren gemäß Anspruch 6 zur Untersuchung oder Präparation einer Probe, das insbesondere zur Anwendung bei einem oben genannten Teilchenstrahlgerät, insbesondere bei einem Elektronenmikroskop vorgesehen ist. Bei dem erfindungsgemäßen Verfahren ist zunächst vorgesehen, daß eine erste Probe an einem ersten Aufnahmeelement eines Trägerelements in einer Vakuumkammer angeordnet wird. Das Trägerelement ist in drei zueinander senkrecht angeordneten Raumrichtungen beweglich angeordnet. Ferner ist es um eine erste Achse, die parallel zur optischen Achse angeordnet ist oder die der optischen Achse entspricht, sowie um eine zweite Achse, die senkrecht zur optischen Achse angeordnet ist, drehbar angeordnet. Die erste Probe, die in dem ersten Aufnahmeelement angeordnet wird, kann recht groß ausgebildet sein. Das Trägerelement wird in mindestens eine erste Stellung bewegt, wobei in der ersten Stellung eine zweite Probe aus der ersten Probe extrahiert wird. Anschließend wird die zweite Probe an einem zweiten Aufnahmeelement des Trägerelements befestigt und das Trägerelement in mindestens eine zweite Stellung bewegt, in der die zweite Probe bestrahlt wird. Durch die Bewegung des Trägerelements werden stets sowohl das erste Aufnahmeelement als auch das zweite Aufnahmeelement in dieselbe Raumrichtung und/oder um dieselbe Achse bewegt.
Vorzugsweise ist es vorgesehen, daß die erste Probe mittels eines ersten Teilchenstrahls untersucht (beispielsweise beobachtet) und die zweite Probe mittels eines zweiten Teilchenstrahls extrahiert wird. Ferner ist es vorgesehen, daß die zweite Probe mittels des ersten Teilchenstrahls in der zweiten Stellung bestrahlt (beispielsweise beobachtet) wird. Bei einer weiteren Ausführungsform ist es vorgesehen, daß die zweite Probe an einer Manipulationsvorrichtung und anschließend mittels der Manipulationsvorrichtung an dem zweiten Aufnahmeelement angeordnet wird. Ferner ist es vorzugsweise vorgesehen, daß die zweite Probe mittels des zweiten Teilchenstrahls präpariert (beispielsweise poliert) und anschließend in der zweiten Stellung mittels des ersten Teilchenstrahls untersucht wird.

Bei einem weiteren, nicht erfindungsgemäßen Verfahren zur Untersuchung oder Präparation einer Probe, insbesondere zur Anwendung bei einem Teilchenstrahlgerät, wird eine Probe an einem Aufnahmeelement eines Trägerelements in einer Vakuumkammer angeordnet, wobei das Aufnahmeelement lösbar mit dem Trägerelement verbunden ist. Durch Lösen des Aufnahmeelements vom Trägerelement und anschließendem Verbinden mit dem Trägerelement wird das Aufnahmeelement in mindestens eine Position, vorzugsweise mindestens zwei Positionen, derart gebracht, daß die Probe mittels eines Teilchenstrahls bestrahlt wird. Vorzugsweise wird das Aufnahmeelement mittels einer Bewegungsvorrichtung in die mindestens eine Position gebracht.

Bei einem weiteren nicht erfindungsgemäßen Verfahren ist es vorgesehen, daß eine erste Probe an einem von zwei Aufnahmeelementen eines Trägerelements in einer Vakuumkammer angeordnet wird, wobei das Trägerelement in drei zueinander senkrecht angeordneten Raumrichtungen beweglich ist und wobei das Trägerelement um eine erste Achse, die parallel zur optischen Achse eines Teilchenstrahlgeräts angeordnet ist oder der optischen Achse entspricht, sowie um eine zweite Achse, die senkrecht zur optischen Achse angeordnet ist, drehbar ist. Ferner wird das Trägerelement in mindestens eine erste Stellung bewegt, wobei in der ersten Stellung die Probe präpariert wird. Anschließend wird das Trägerelement in mindestens eine zweite Stellung bewegt, in der die Probe untersucht wird. Durch die Bewegung des Trägerelements werden stets das erste Aufnahmeelement und das zweite Aufnahmeelements in dieselbe Raumrichtung und/oder um dieselbe Achse bewegt. Beispielsweise ist es mit dem hier beschriebenen Verfahren möglich, daß das Trägerelement zwischen einer Position, in der eine Probe poliert wird, und einer Position bewegt wird, in der die Probe beispielsweise mit einem Transmissionsmeßverfahren untersucht wird.

Nachfolgend wird die Offenbarung mittels Figuren anhand von Ausführungsbeispielen bzw. nicht erfindungsgemäßen Ausgestaltungen (also Beispielen, die das Verständnis der Erfindung erleichtern) näher beschrieben. Dabei zeigen
- Fig. 1: eine schematische Darstellung eines Teilchenstrahlgeräts mit einer Vakuumkammer;
- Fig. 2: eine weitere schematische Darstellung des Teilchenstrahlgeräts nach Figur 1;
- Fig. 3: eine schematische Darstellung eines weiteren Teilchenstrahlgeräts mit einer Vakuumkammer;
- Fig. 4: eine schematische Darstellung eines Trägerelements;
- Fig. 5: eine weitere schematische Darstellung des Trägerelements nach Figur 4;
- Fig. 6: eine weitere schematische Darstellung des Teilchenstrahlgeräts nach Figur 1, wobei eine an einem Aufnahmeelement befestigte Probe untersucht wird;
- Fig. 7: eine weitere schematische Darstellung des Teilchenstrahlgeräts nach Figur 1, wobei eine an einem Aufnahmeelement befestigte Probe bearbeitet wird;
- Fig. 8: eine weitere schematische Darstellung des Teilchenstrahlgeräts nach Figur 1 mit einem Mikromanipulator;
- Fig. 9: eine weitere schematische Darstellung des Teilchenstrahlgeräts nach Figur 1 mit dem Mikromanipulator;
- Fig. 10: eine weitere schematische Darstellung des Teilchenstrahlgeräts nach Figur 1 mit dem Mikromanipulator;
- Fig. 11: eine weitere schematische Darstellung des Teilchenstrahlgeräts nach Figur 1 mit dem Mikromanipulator;
- Fig. 12: eine schematische Darstellung einer Probenpräparation in dem Teilchenstrahlgerät nach Figur 1;
- Fig. 13: eine schematische Darstellung einer Probenuntersuchung in dem Teilchenstrahlgerät nach Figur 1;
- Fig. 14: eine schematische Darstellung einer ersten Teilchenstrahlsäule in Form einer Elektronensäule;
- Fig. 15: eine schematische Darstellung einer zweiten Teilchenstrahlsäule in Form einer Ionensäule;
- Fig. 16: eine schematische Darstellung eines weiteren Trägerelements in einer ersten Position; sowie
- Fig. 17: eine schematische Darstellung des Trägerelements nach Figur 16 in einer zweiten Position.

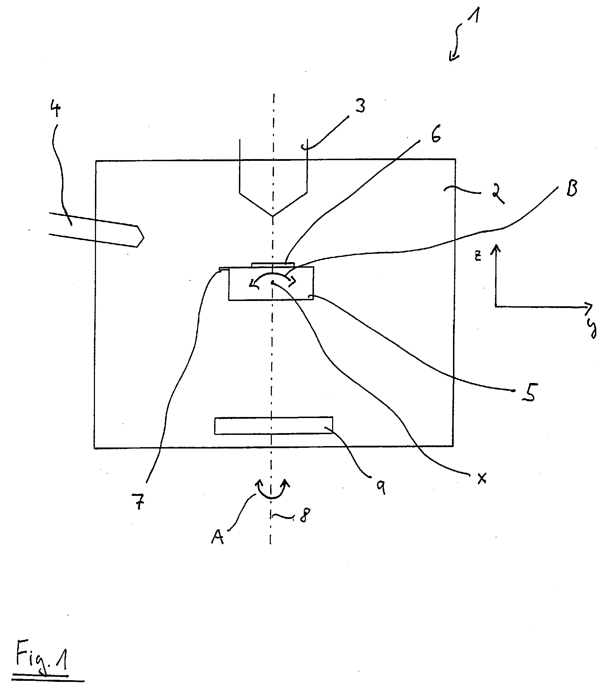

Figur 1 zeigt eine schematische Darstellung eines Teilchenstrahlgeräts 1 in Form eines Rasterelektronenmikroskops, welches mit einer Ionenstrahleinrichtung ausgebildet ist. An einer Vakuumkammer 2 sind daher sowohl eine erste Teilchenstrahlsäule 3 in Form einer Elektronensäule als auch eine zweite Teilchenstrahlsäule 4 in Form einer Ionensäule angeordnet. Auf den Aufbau der einzelnen Teilchenstrahlsäulen 3 und 4 wird weiter unten noch näher eingegangen.

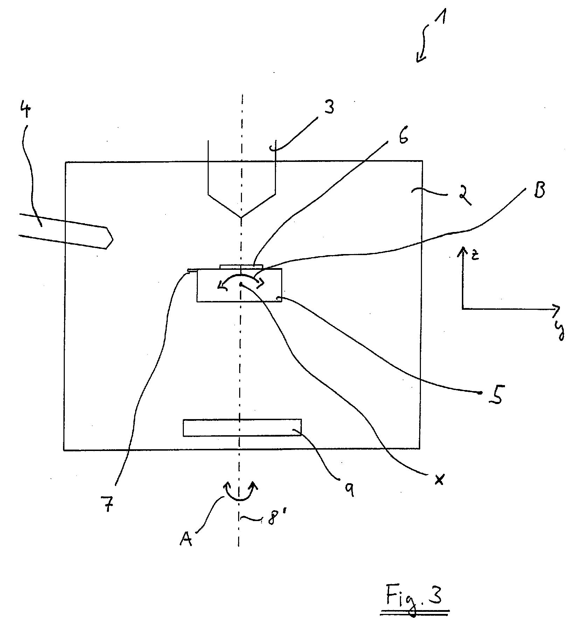

In der Vakuumkammer 2 ist ferner ein Trägerelement 5 in Form eines Probentisches angeordnet. Das Trägerelement 5 ist in drei zueinander senkrecht angeordneten Raumrichtungen x, y, und z beweglich ausgebildet. Die Raumrichtungen z und y sind seitlich der Vakuumkammer 2 dargestellt. Die Raumrichtung x steht senkrecht auf der Blattebene. Zusätzlich ist das Trägerelement 5 um eine Achse 8 drehbar angeordnet, was durch den Pfeil A dargestellt ist. Die Achse 8 ist parallel zu einer ersten optischen Achse der ersten Teilchenstrahlsäule 3 angeordnet. Bei einem weiteren Ausführungsbeispiel, was dem in Figur 1 dargestellten Ausführungsbeispiel im gesamten Aufbau und in der Funktion entspricht sowie in der Figur 3 dargstellt ist, entspricht die Achse 8 der ersten optischen Achse 8'. Bevorzugt ist das Trägerelement 5 um maximal 180°, vorzugsweise bis zu maximal 240° oder 300° und noch bevorzugter bis zu maximal 360° um die Achse 8 drehbar.

Ferner ist das Trägerelement 5 auch um die Raumrichtungsachse x schwenkbar, die senkrecht auf der Achse 8 und somit auch senkrecht auf der ersten optischen Achse steht. Die Verschwenkbarkeit ist durch einen Pfeil B dargestellt. Die Verschwenkung erfolgt zu beiden Seiten des Pfeiles B in einem Bereich von maximal ca. 90°, vorzugsweise in einem Bereich bis zu maximal 60° oder 45° und noch bevorzugter in einem Bereich bis zu maximal 30°. In einem ganz speziellen Fall erfolgt die Verschwenkung um maximal 15° in die eine Richtung und um maximal 60° in die andere Richtung.

Das Trägerelement 5 ist mit einem ersten Aufnahmeelement 6 versehen, an dem eine erste Probe angeordnet wird. Zusätzlich ist das Trägerelement 5 mit einem zweiten Aufnahmeelement 7 versehen, an dem eine zweite Probe angeordnet wird. Hierauf wird weiter unten noch näher eingegangen.

In der Vakuumkammer 2 ist ferner von der ersten Teilchenstrahlsäule 3 in Richtung der Achse 8 ein Detektor 9 angeordnet, der dazu geeignet ist, aus einer Probe austretende gestreute oder transmittierte Elektronen zu detektieren. Beispielsweise ist ein Detektor gemäß der WO 2005/006384 A2 vorgesehen.

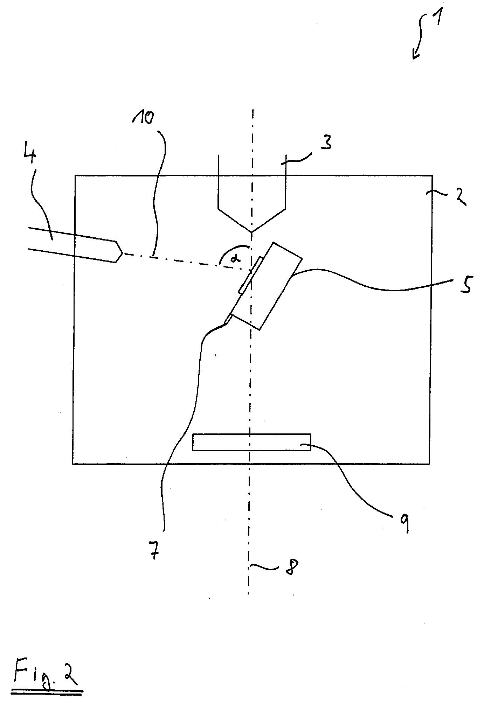

Die zweite Teilchenstrahlsäule 4 weist eine zweite optische Achse 10 auf. Die erste Teilchenstrahlsäule 3 und die zweite Teilchenstrahlsäule 4 sind dabei derart zueinander angeordnet, daß die erste optische Achse und die zweite optische Achse 10 unter einem Winkel α gekippt zueinander angeordnet sind (vgl. Figur 2). Der Winkel α liegt in einem Bereich von 20° bis 90°. In ganz speziellen Fällen liegt er bei ca. 54°.

Das erfindungsgemäße Teilchenstrahlgerät 1 sowie das hierauf anwendbare erfindungsgemäße Verfahren werden nun nachfolgend auch anhand der weiteren Figuren erläutert.

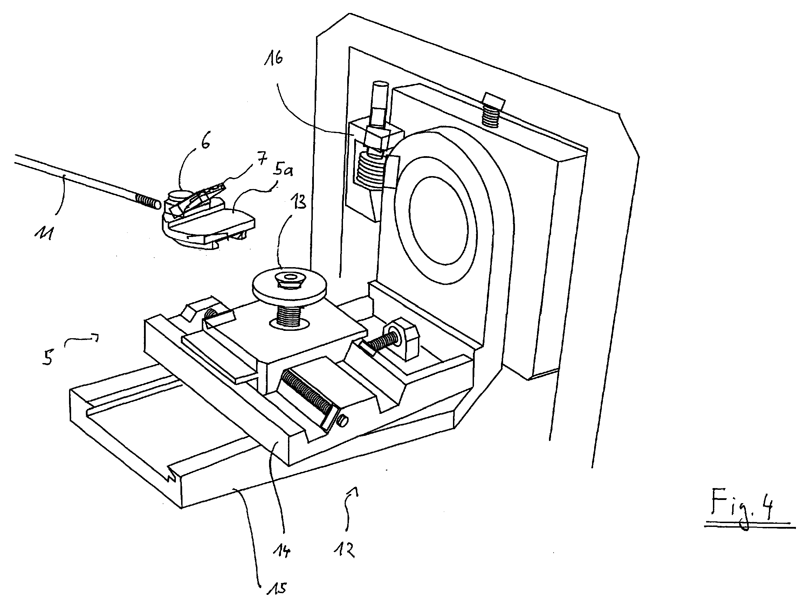

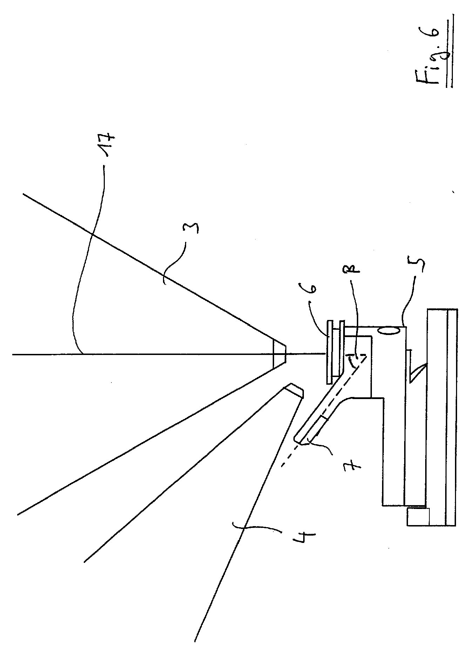

Figur 4 zeigt das Einschleusen eines Halters 5a des Trägerelements 5, an dem sowohl das erste Aufnahmeelement 6 als auch das zweite Aufnahmeelement 7 angeordnet sind. Das erste Aufnahmeelement 6 und das zweite Aufnahmeelement 7 weisen Aufnahmeflächen auf, deren Flächennormalen einen Winkel β zueinander einschließen, der dem Winkel α entspricht. Dabei ist die Flächennormale des zweiten Aufnahmeelements 7 bei diesem Ausführungsbeispiel parallel zu einer Längsachse des Aufnahmeelements 7 angeordnet, welches die Form eines Armes aufweist (vgl. Figur 6). Der Winkel β liegt in einem Bereich von 20° bis 90° und in besonderen Fällen bei ca. 54°. Das letztere gewährleistet bei einer Anordnung der Teilchenstrahlsäulen 3 und 4 von 54° zueinander, daß das Trägerelement mit einer auf dem Aufnahmeelement 7 angeordneten Probe bei einer Bestrahlung mit Ionen nicht gekippt werden braucht.

Im Unterschied zu dem Ausführungsbeispiel gemäß der Figur 4 sind die Aufnahmeelemente 6 und 7 gemäß den Figuren 1 bis 3 um einen Winkel β von ungefähr 90° versetzt angeordnet.

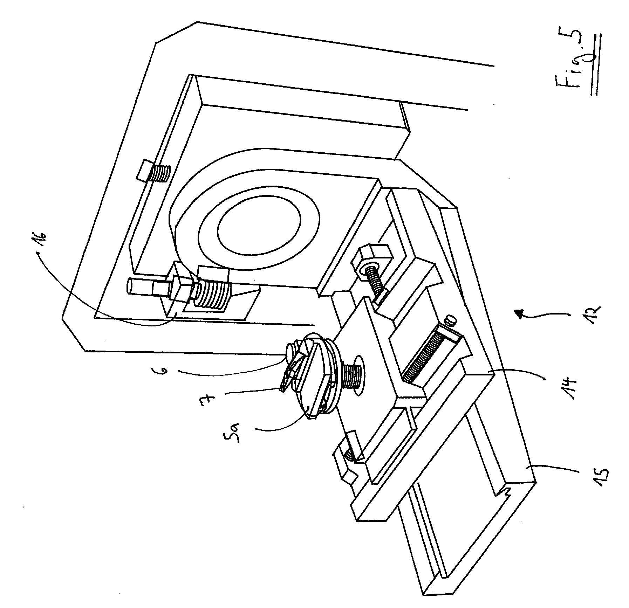

Wie aus Figur 4 ersichtlich, wird mittels eines Manipulators 11 der Halter 5a an einem weiteren Halter 13 des Trägerelements 5 angeordnet. Das Trägerelement 5 ist mit einer Positioniervorrichtung 12 versehen, die eine Schlittenmechanik 14 zur Verstellung in der y-Richtung sowie eine Schlittenmechanik 15 zur Verstellung in der x-Richtung aufweist. Ferner ist noch eine Verschiebevorrichtung 16 zur Verstellung in z-Richtung vorgesehen. Die Mechaniken zur oben beschriebenen Rotation sind in Figur 4 nicht dargestellt. Figur 5 zeigt das Ausführungsbeispiel gemäß Figur 4 nach abgeschlossener Einschleusung.

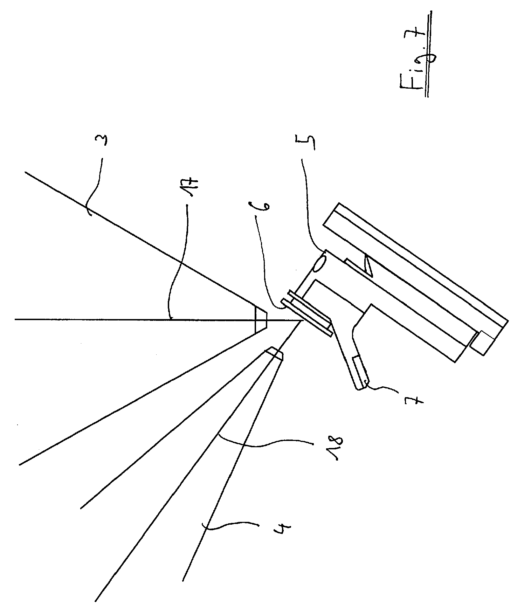

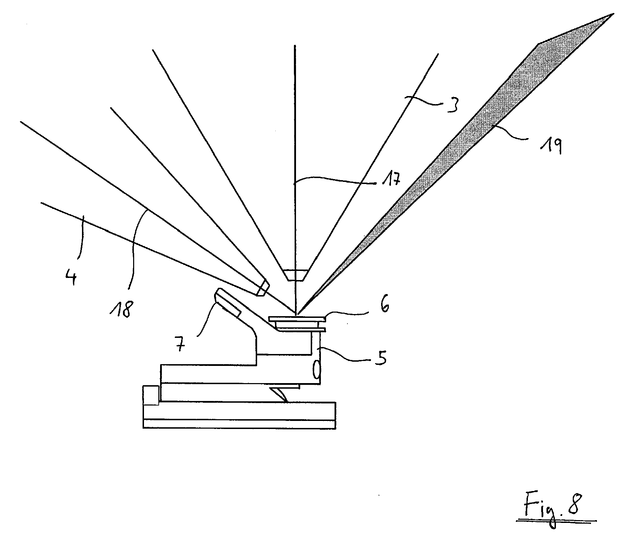

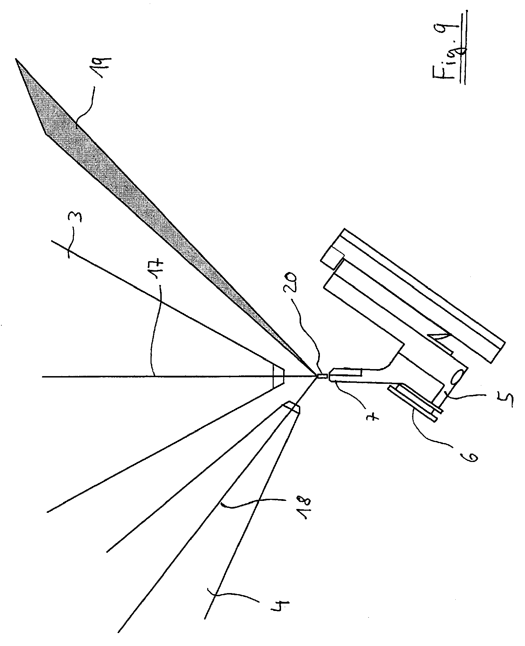

Figur 6 zeigt nun schematisch einen weiteren Verfahrensschritt. Mittels eines Elektronenstrahls 17, der im wesentlichen senkrecht auf die auf dem ersten Aufnahmeelement 6 angeordnete erste Probe gerichtet ist, wird eine Abbildung der Probenoberfläche (Rasterbild) erzeugt und ein für weitere Untersuchungen interessanter Bereich ermittelt. Anschließend wird das Trägerelement 5 derart gekippt, daß dieser interessante Bereich der auf dem ersten Aufnahmeelement 6 angeordneten ersten Probe im wesentlichen senkrecht zu einem auf die erste Probe einfallenden Ionenstrahl 18 angeordnet ist (vgl. Figur 7). In dieser Position wird eine zweite Probe, die Teil der ersten Probe ist, mittels des Ionenstrahls 18 präpariert. Zusätzlich hierzu kann bereits jetzt die zweite Probe aus der ersten Probe mittels des Ionenstrahls 18 herausgeschnitten werden. Sowohl das Herausschneiden als auch das Präparieren sind mittels des Elektronenstrahls 17 durch Rasterbildgebung beobachtbar. Bei dem in den Figuren dargestellten Ausführungsbeispiel sind zwei mögliche Arten vorgesehen, um die zweite Probe weiterzubehandeln. Die erste Art ist in den Figuren 8 und 9 dargestellt. Bei dieser Art ist die Oberfläche (Aufnahmefläche) des ersten Aufnahmeelements 6 senkrecht zur optischen Achse der ersten Teilchenstrahlsäule 3 ausgerichtet. Mittels des Ionenstrahls 18 wird die zweite Probe aus der ersten Probe herausgeschnitten. Beispielsweise wird dies mit einem Verfahren durchgeführt, das aus der US 6,963,068 B2 bekannt ist. Das Herausschneiden wird mittels des Elektronenstrahls 17 durch Rasterbildgebung beobachtet. Mittels eines beweglich ausgebildeten Mikromanipulators 19 wird anschließend die zweite Probe aus der ersten Probe herausgehoben (Lift-Out). Hierzu wird zuvor die zweite Probe an dem Mikromanipulator 19 fixiert. Dazu wird der Mikromanipulator 19 in die Nähe der ersten Probe derart gebracht, daß die zweite Probe an dem Mikromanipulator 19 befestigt werden kann. Die Erfindung ist nicht auf eine bestimmte Befestigungsart eingeschränkt. Vielmehr ist jede Befestigungsart verwendbar, die zur Befestigung der zweiten Probe an dem Mikromanipulator 19 geeignet ist. Beispielsweise kann die zweite Probe an dem Mikromanipulator 19 mittels einer Klemmvorrichtung befestigt werden. Alternativ oder zusätzlich hierzu erfolgt die Befestigung der zweiten Probe an dem Mikromanipulator 19 mittels einer ionenstrahlinduzierten Abscheidungsschicht, die durch fokussierte Ionenstrahlen in einer Gasatmosphäre erzeugt wird. Ein derartiges Befestigungsverfahren ist beispielsweise aus der DE 42 26 694 C2 bekannt.

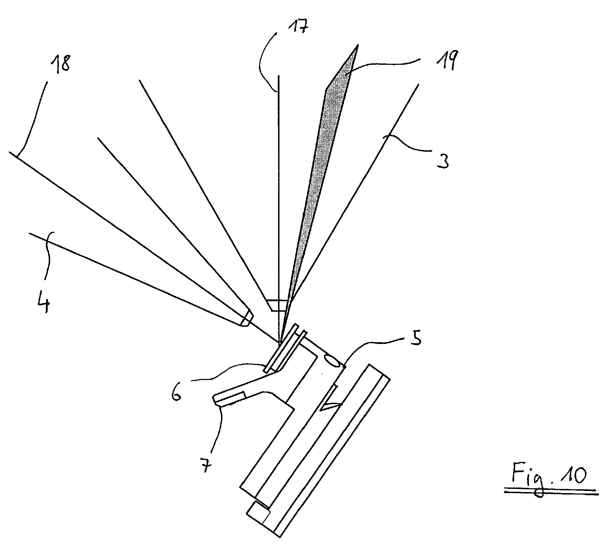

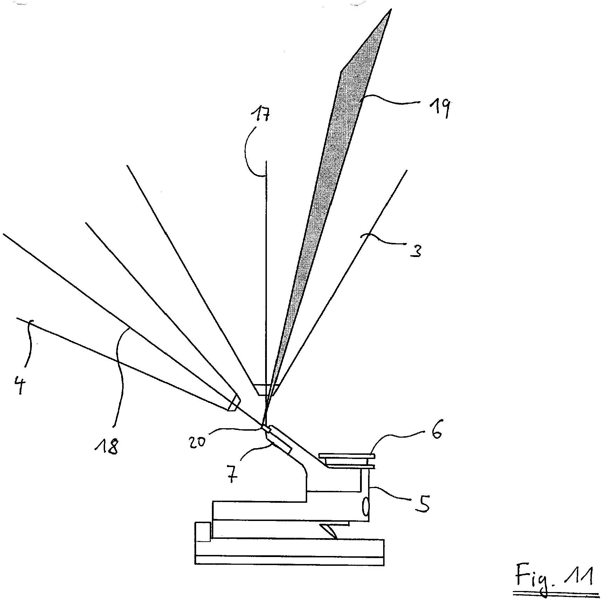

Nach Befestigung der zweiten Probe an dem Mikromanipulator 19 wird die zweite Probe aus der ersten Probe extrahiert und in einem weiteren Verfahrensschritt an dem zweiten Aufnahmeelement 7 befestigt. Dies ist in Figur 9 näher dargestellt. Hierzu wird bei dem dargestellten Ausführungsbeispiel das Trägerelement 5 derart bewegt, daß die Flächennormale der Aufnahmefläche des zweiten Aufnahmeelements 7 parallel zur optischen Achse der ersten Teilchenstrahlsäule 3 (Elektronensäule) ausgerichtet ist. Mittels der Rasterbildgebung durch den Elektronenstrahl 17 ist dann beobachtbar, wie mittels des Ionenstrahls 18 die zweite Probe 20 von dem Mikromanipulator 19 gelöst und an dem zweiten Aufnahmeelement 7 befestigt wird. Als Befestigungsart ist wieder jede Art wählbar, die zur Befestigung der zweiten Probe an dem zweiten Aufnahmeelement 7 geeignet ist, beispielsweise die bereits oben genannten Befestigungsarten.
Die zweite Art der Weiterbehandlung ist in den Figuren 10 und 11 dargestellt. Die zweite Art unterscheidet sich jedoch von der ersten Art nur dahingehend, daß das Herausschneiden und Herausheben bei einer Position erfolgt, in der das Trägerelement 5 gekippt ist und die Aufnahmefläche des ersten Aufnahmeelements senkrecht zur optischen Achse der zweiten Teilchenstrahlsäule 4 angeordnet ist. Alle in Bezug auf die Figuren 8 und 9 erläuterten Schritte sind daher auch auf das in den Figuren 10 und 11 dargestellte Ausführungsbeispiel anwendbar, wobei die Fixierung der zweiten Probe 20 an dem zweiten Aufnahmeelement 7 dann erfolgt, wenn die Aufnahmefläche des ersten Aufnahmeelements 6 senkrecht zur optischen Achse der ersten Teilchenstrahlsäule 3 ausgerichtet ist.

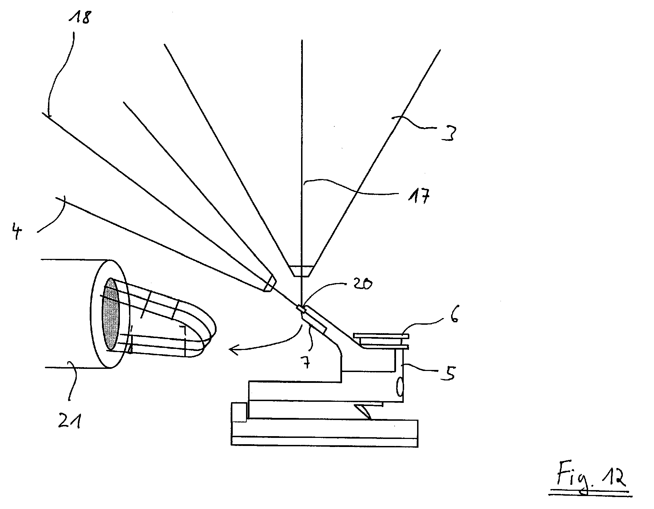

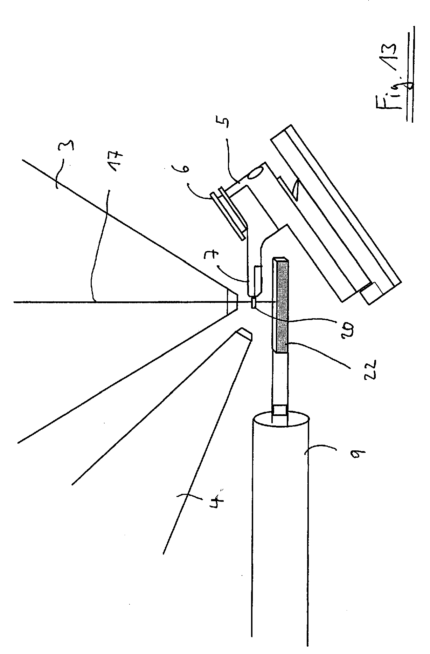

In einem weiteren Verfahrensschritt wird die zweite Probe 20 weiter präpariert. In dem Ausführungsbeispiel gemäß der Figur 12 ist die zweite Probe 20 durch Bewegen des Trägerelements 5 derart zu dem Ionenstrahl 18 gerichtet, daß die zweite Probe 20 poliert wird. Dieser Vorgang ist mittels der Elektronenstrahls 17 durch Rasterbildgebung beobachtbar. Das Polieren erfolgt solange, bis eine Elektronentransparenz an Probenbereichen mit kleinem Z auftritt. Die aufgrund der Elektronentransparenz durch die zweite Probe 20 durchtretenden Elektronen werden mittels eines Detektors 21 ermittelt. Anschließend wird das Trägerelement 5 wieder derart bewegt bzw. geschwenkt, daß die zweite Probe 20 im Grunde senkrecht mit dem Elektronenstrahl 17 beaufschlagt werden kann. Mittels des Elektronenstrahls 17 werden Elektronen auf die an dem zweiten Aufnahmeelement 7 angeordnete zweite Probe 20 geleitet. Unterhalb der zweiten Probe 20 ist der Detektor 9 mit einer Detektorfläche 22 angeordnet. Somit es möglich, die von der zweiten Probe 20 gestreuten Elektronen oder durch die zweite Probe 20 transmittierten Elektronen mittels des Detektors 9 zu detektieren und zur Bildgebung zu verwenden (vgl. Figur 13). Hierdurch sind Rückschlüsse auf die zweite Probe 20 möglich. Insbesondere kann festgestellt werden, ob die Präparation der zweiten Probe 20 ausreichend war oder nochmals wiederholt werden muß.

Die Erfindung weist auch den Vorteil auf, daß die Aufnahmeelemente 6 und 7 keine Bewegungsmechaniken aufweisen, da sämtliche notwendigen Bewegungen über die Bewegungsfreiheitsgrade des Trägerelements 5 realisierbar sind. Da der Winkel α zwischen den optischen Achsen der Teilchenstrahlsäulen 3 und 4 dem Winkel β der Aufnahmeelemente 6 und 7 entspricht, ist es oft nicht notwendig, das Trägerelement 5 zu bewegen, wenn die optische Achse der ersten Teilchenstrahlsäule 3 senkrecht auf der Oberfläche des Aufnahmeelements 6 steht und die an dem Aufnahmeelement 7 angeordnete Probe mit einem Ionenstrahl beaufschlagt werden soll, da die Probe sich dann bereits in einer guten Position zur Bestrahlung befindet.

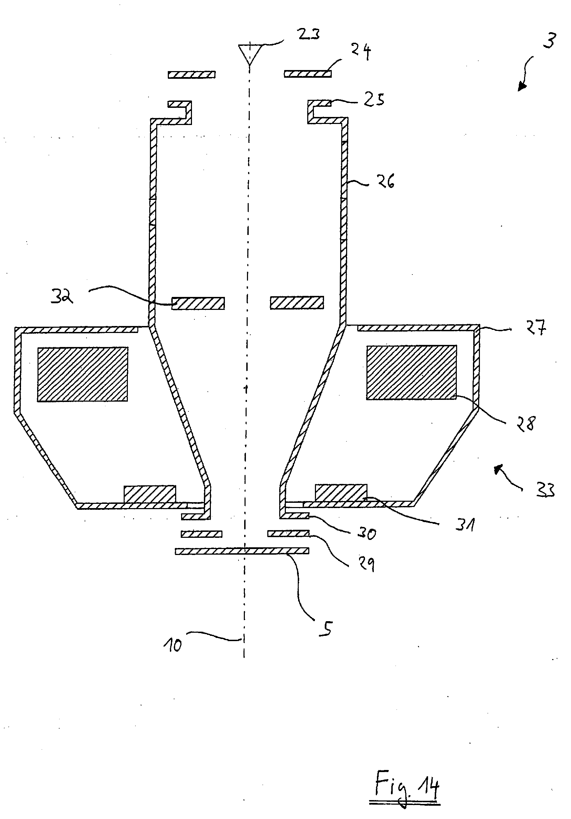

Figur 14 zeigt eine schematische Darstellung der ersten Teilchenstrahlsäule 3, die als Elektronensäule ausgebildet ist und im Grunde einer Elektronensäule eines Rasterelektronenmikroskops entspricht. Die erste Teilchenstrahlsäule 3 weist einen Strahlerzeuger in Form einer Elektronenquelle 23 (Kathode), eine Extraktionselektrode 24 sowie eine Anode 25 auf, die gleichzeitig ein Ende eines Strahlführungsrohrs 26 bildet. Vorzugsweise ist die Elektronenquelle 23 ein thermischer Feldemitter. Elektronen, die aus der Elektronenquelle 23 austreten, werden aufgrund einer Potentialdifferenz zwischen der Elektronenquelle 23 und der Anode 25 auf Anodenpotential beschleunigt. Ferner ist eine Objektivlinse 33 vorgesehen, die eine Bohrung aufweist, durch welche das Strahlführungsrohr 26 tritt. Die Objektivlinse 33 weist ferner Polschuhe 27 auf, in denen Spulen 28 angeordnet sind, wie sie bereits seit langem bekannt sind. Hinter das Strahlführungsrohr 26 ist eine elektrostatische Verzögerungseinrichtung geschaltet. Diese besteht aus einer Einzelelektrode 29 und einer Rohrelektrode 30, die an dem dem Trägerelement 5 gegenüberliegenden Ende des Strahlführungsrohrs 26 ausgebildet ist. Das in der Figur 14 dargestellte Trägerelement 5 entspricht dem in den Figuren 1 bis 13 dargestellten Trägerelement 5. Es wird darauf hingewiesen, daß der in Figur 14 dargestellte Abstand des Trägerelements 5 von der Einzelelektrode 29 nur schematisch zu verstehen und derart ausreichend ist, daß eine Bestrahlung einer auf dem Trägerelement 5 angeordneten Probe durch einen Ionenstrahl, der mittels der zweiten Teilchenstrahlsäule 4 erzeugt wird, ohne weiteres möglich ist.

Die Rohrelektrode 30 liegt gemeinsam mit dem Strahlführungsrohr 26 auf Anodenpotential, während die Einzelelektrode 29 sowie eine auf dem Trägerelement 5 angeordnete Probe auf einem gegenüber dem Anodenpotential niedrigeren Potential liegen. Auf diese Weise können die Elektronen des Elektronenstrahls auf eine gewünschte niedrige Energie abgebremst werden, die für die Untersuchung einer auf dem Trägerelement 5 angeordneten Probe erforderlich ist. Die erste Teilchenstrahlsäule 3 weist zudem Rastermittel 31 auf, durch die der Elektronenstrahl abgelenkt und über eine auf dem Trägerelement 5 angeordnete Probe gerastert werden kann.

Zur Bildgebung werden mittels eines im Strahlführungsrohr 26 angeordneten Detektors 32 Sekundärelektronen und/oder Rückstreuelektronen, die aufgrund der Wechselwirkung des Elektronenstrahls mit einer auf dem Trägerelement 5 angeordneten Probe entstehen, verwendet. Die von dem Detektor 32 erzeugten Signale werden zur Bildgebung an eine Elektronikeinheit (nicht dargestellt) übermittelt.

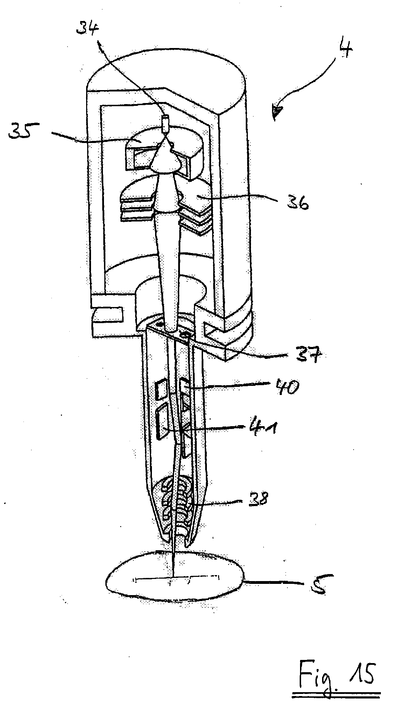

Figur 15 zeigt den Aufbau der zweiten Teilchenstrahlsäule 4 in Form der Ionensäule. Im Grunde entspricht der Aufbau der zweiten Teilchenstrahlsäule 4 dem Aufbau der ersten Teilchenstrahlsäule 3. Mittels eines Ionenstrahlerzeugers 34 werden Ionen (Ionenstrahl) erzeugt und mittels einer Extraktionselektrode 35 auf ein gewisses Potential beschleunigt. Der Ionenstrahl gelangt dann durch eine Ionenoptik der zweiten Teilchenstrahlsäule 4, wobei die Ionenoptik eine Kondensorlinse 36 und eine Anordnung von einzelnen Linsen 38 aufweist. Die Linsen 38 (Objektivlinse) erzeugen schließlich eine Ionensonde, die auf eine auf dem Trägerelement 5 angeordnete Probe trifft. Oberhalb der Linsen 38 (also in Richtung des Ionenstrahlerzeugers 34) sind eine einstellbare Blende 37 und zwei Elektrodenanordnungen 40 und 41 angeordnet, wobei die Elektrodenanordnungen als Rasterelektroden ausgebildet sind. Mittels dieser Rasterelektroden 40 und 41 wird der Ionenstrahl über eine auf dem Trägerelement 5 angeordnete Probe gerastert. Das Trägerelement 5 entspricht auch hier dem Trägerelement 5 gemäß den Figuren 1 bis 13. Der Abstand des Trägerelements 5 von dem Ende der zweiten Teilchenstrahlsäule 4 ist nur schematisch zu verstehen. Selbstverständlich ist das Trägerelement 5 derart angeordnet, daß eine gleichzeitige Bestrahlung einer auf dem Trägerelement 5 angeordneten Probe durch einen Elektronenstrahl, der mittels der ersten Teilchenstrahlsäule 3 erzeugt wird, ohne weiteres möglich ist.

Durch die Anordnung des ersten Aufnahmeelements 6 und des zweiten Aufnahmeelements 7 an dem Trägerelement 5 ist es einfach möglich, aus einer ersten Probe eine zweite Probe zu extrahieren, die zweite Probe zu präparieren und zu untersuchen, ohne daß die zweite Probe aus der Vakuumkammer 2 ausgeschleust werden muß.

Bei einigen Untersuchungen ist es manchmal nicht notwendig, eine zweite Probe aus einer ersten Probe herauszuschneiden, zu präparieren und zu untersuchen. Vielmehr wird hier eine vorpräparierte Probe auf dem Trägerelement 5 in die Vakuumkammer 2 eingeschleust, wobei die vorpräparierte Probe an dem zweiten Aufnahmeelement 7 angeordnet ist. Im Grunde wird bei diesem Verfahren dann zwischen zwei Positionen des Trägerelements 5 hin- und herbewegt. In einer ersten Position erfolgt ein Polieren der vorpräparierten Probe. Dies entspricht im Grunde der Figur 12. In einer zweiten Position erfolgt die weitere Untersuchung der Probe durch Bildgebung, wie sie beispielsweise in Figur 13 dargestellt ist.

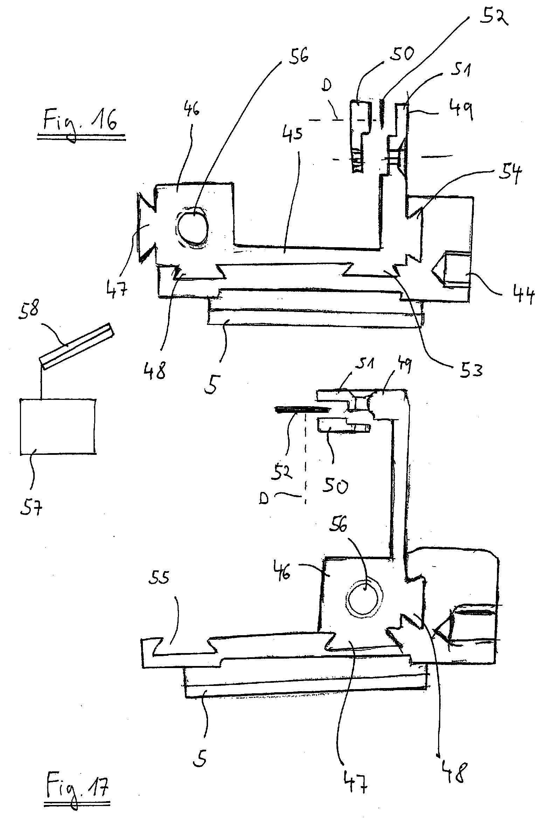

Die Figuren 16 und 17 zeigen eine nicht erfindungsgemäße Ausgestaltung, die in das Teilchenstrahlgerät 1 mit den zwei Teilchenstrahlsäulen 3 und 4 einbringbar ist. Die in den Figuren 16 und 17 dargestellte Ausgestaltung weist ein Trägerelement 5 auf, das vorzugsweise genauso beweglich ausgebildet ist, wie das bereits oben beschriebene Trägerelement 5. Es kann in eine Vakuumkammer mittels eines Manipulators eingebracht werden, der vorzugsweise an einem Gewinde 44 des Trägerelements 5 angeordnet wird.

An dem Trägerelement 5 ist ein Aufnahmeelement 45 lösbar verbunden. Dabei ist das Aufnahmeelement 45 derart mit dem Trägerelement 5 verbindbar, daß das Aufnahmeelement 45 mindestens zwei Winkelstellungen einnehmen kann. Die Winkelstellungen sind bevorzugt in einem Winkel von 20° bis 160° zueinander angeordnet. Bei der in den Figuren 16 und 17 dargestellten ausgestaltung sind zwei Winkelstellungen (Position 1 in Figur 16 und Position 2 in Figur 17) vorgesehen, die 90° zueinander versetzt angeordnet sind. Um diese Winkelstellungen einnehmen zu können, sind an dem Aufnahmeelement 45 und dem Trägerelement 5 entsprechend der gewünschten Winkelstellung Führungselemente vorgesehen, welche die Winkelstellungen festlegen. Bei der in den Figuren 16 und 17 dargestellten Ausgestaltung weist das Aufnahmeelement 45 an einem ersten Ende 46 schwalbenschwanzförmige Führungselemente 47 und 48 auf. Ferner sind weitere Führungselemente 53 und 54 vorgesehen, welche in Figur 17 aus Gründen der Übersichtlichkeit nicht dargestellt sind. Die Führungselemente 47, 48, 53 und 54 sind derart in zu den Führungselementen 47, 48, 53 und 54 komplementär ausgebildete Führungsaufnahmen 55 angeordnet, daß das Aufnahmeelement 45 nach Lösen vom Trägerelement 5 und anschließendem Wiederverbinden mit dem Aufnahmeelement 45 in die zwei zueinander unter 90° angeordneten Positionen (Winkelstellungen) bringbar ist. Das Aufnahmeelement 45 wird dabei durch eine schematisch dargestellte Manipulatorvorrichtung 58 bewegt (das heißt von dem Trägerelement 5 in einer Position gelöst - beispielsweise die Position in Figur 16 - und in einer anderen Position wieder mit dem Trägerelement 5 verbunden - beispielsweise die Position in Figur 17). Wie oben gesagt, ist die Manipulatorvorrichtung 58 nur schematisch in Figur 16 dargestellt. Sie ist rein mechanisch bewegbar oder ist mittels einer schematisch dargestellten Steuereinheit 57 und einem in dieser enthaltenden Elektromotor auch elektrisch sowie automatisch bewegbar. Um das Aufnahmeelement 45 bewegen zu können, greift die Manipulatorvorrichtung 58 in eine Gewindeaufnahme 56 des Aufnahmeelements 45 ein.

An einem zweiten Ende 49 des Aufnahmeelements 45 sind Klemmbacken 50 und 51 angeordnet, zwischen denen eine Probe 52 (beispielsweise ein Gitter für ein Transmissionselektronenmikroskop) vor Einschleusung des Trägerelements 5 sowie des Aufnahmeelements 45 angeordnet wird. Mittels der Manipulatorvorrichtung 58 ist das Aufnahmeelement 45 in die in Figur 16 dargestellte Position bringbar, in der es beispielsweise mittels eines Ionenstrahls aus der Ionenstrahlsäule bestrahlt wird. Anschließend ist das Aufnahmeelement 45 in die Position gemäß Figur 17 bringbar, in der es beispielsweise mittels einer Raster-Transmissionselektronenmikroskopie-Untersuchung eingehend untersucht wird. Die Figuren 16 und 17 zeigen auch die Aufnahmeachse D im Bereich der Klemmbacken 50, die in den verschiedenen Positionen bei dieser Ausgestaltung unter 90° angeordnet sind.

Es wird ausdrücklich darauf hingewiesen, daß die Erfindung bzw. der nicht als Erfindung beanspruchte Teil der Offenbarung nicht auf eine Kombination einer Elektronensäule mit einer Ionensäule eingeschränkt ist. Vielmehr kann das erfindungsgemäße Teilchenstrahlgerät Säulen aufweisen, die jegliche Teilchenart erzeugen und führen. Auch kann das nicht erfindungsgemäße Teilchenstrahlgerät nur mit einer einzelnen Säule ausgebildet sein. Auch können, nicht erfindungsgemäß, statt Teilchen Laserstrahlen verwendet werden.

### Bezugszeichenliste

- 1: Teilchenstrahlgerät
- 2: Vakuumkammer
- 3: erste Teilchenstrahlsäule
- 4: zweite Teilchenstrahlsäule
- 5: Trägerelement
- 5a: Halter
- 6: erstes Aufnahmeelement
- 7: zweites Aufnahmeelement
- 8: Achse
- 8': optische Achse
- 9: Detektor
- 10: optische Achse
- 11: Manipulator
- 12: Positioniervorrichtung
- 13: Halter
- 14: Schlittenmechanik
- 15: Schlittenmechanik
- 16: Verschiebevorrichtung
- 17: Elektronenstrahl
- 18: Ionenstrahl
- 19: Mikromanipulator
- 20: zweite Probe
- 21: Detektor
- 22: Detektor
- 23: Elektronenquelle
- 24: Extraktionselektrode
- 25: Anode
- 26: Strahlführungsrohr
- 27: Polschuhe
- 28: Spulen
- 29: Einzelelektrode
- 30: Rohrelektrode
- 31: Rastermittel
- 32: Detektor
- 33: Objektivlinse
- 34: Ionenstrahlerzeuger
- 35: Extraktionselektrode
- 36: Kondensorlinse
- 37: variable Blende
- 38: Linsenanordnung (Objektivlinse)
- 39 40: Rasterelektroden
- 41: Rasterelektroden
- 42 43 44: Gewinde
- 45: Aufnahmeelement
- 46: erstes Ende
- 47: Führungselement
- 48: Führungselement
- 49: zweites Ende
- 50: Klemmbacke
- 51: Klemmbacke
- 52: Probe
- 53: Führungselement
- 54: Führungselement
- 55: Führungsaufnahme
- 56: Gewindeaufnahme
- 57: Steuereinheit
- 58: Manipulatoreinheit

## Patentansprüche

1. Teilchenstrahlgerät (1), mit
- einer ersten Teilchenstrahlsäule (3) mit einer ersten optischen Achse (8),
- einer zweiten Teilchenstrahlsäule (4) mit einer zweiten optischen Achse (10), wobei die erste optische Achse (8) und die zweite optische Achse (10) einen Winkel (α) einschließen,
- mindestens einem Trägerelement (5), das in drei zueinander senkrecht angeordneten Raumrichtungen (x, y, z) beweglich ausgebildet ist und das um eine erste Achse (8) sowie um eine zweite Achse (x), die senkrecht zur ersten Achse (8) angeordnet ist, drehbar ist,
- mindestens einem ersten Aufnahmeelement (6) zur Aufnahme einer ersten Probe und mit mindestens einem zweiten Aufnahmeelement (7) zur Aufnahme einer zweiten Probe, wobei das erste Aufnahmeelement (6) und das zweite Aufnahmeelement (7) derart an dem Trägerelement (5) angeordnet sind, dass eine Bewegung des Trägerelements (5) stets eine Bewegung des ersten Aufnahmeelements (6) und des zweiten Aufnahmeelements (7) in dieselbe Raumrichtung (x, y, z) und/oder um dieselbe Achse (8, 8', x) bedingt, wobei das erste Aufnahmeelement (6) und das zweite Aufnahmeelement (7) keine Bewegungsmechaniken aufweisen,
- wobei das Trägerelement (5) in mindestens eine erste Stellung und in mindestens eine zweite Stellung bewegbar ist, wobei in der ersten Stellung eine erste Probe in dem ersten Aufnahmeelement (6) mittels eines Teilchenstrahls bestrahlbar ist und wobei in der zweiten Stellung eine zweite Probe in dem zweiten Aufnahmeelement (7) mittels eines Teilchenstrahls bestrahlbar ist,
wobei
- das erste Aufnahmeelement (6) eine erste Aufnahmefläche aufweist, welche in einer ersten Ebene liegt, und das zweite Aufnahmeelement (7) eine zweite Aufnahmefläche aufweist, welche in einer zweiten Ebene liegt,
- die erste Ebene und die zweite Ebene um einen Winkel (β) im Bereich von 10° bis 90° zueinander versetzt angeordnet sind, der dem Winkel (α) zwischen der ersten optischen Achse (8) und der zweiten optischen Achse (10) entspricht,
- die erste Aufnahmefläche und die zweite Aufnahmefläche derart zueinander ausgerichtet sind, dass in einer ersten Rotationsposition um die zweite Achse die erste Ebene senkrecht zu der ersten optischen Achse ausgerichtet ist und dass in einer zweiten Rotationsposition um die zweite Achse die zweite Ebene senkrecht zu der ersten optischen Achse ausgerichtet ist, und wobei
- ein Detektor (9, 22) - von einem Strahlerzeuger (23, 34) in Richtung des Trägerelements (5) aus gesehen - hinter dem Trägerelement (5) angeordnet ist.

2. Teilchenstrahlgerät (1) nach Anspruch 1, wobei
- die erste Teilchenstrahlsäule (3) den Strahlerzeuger (23) in Form eines ersten Strahlerzeugers zur Erzeugung eines ersten Teilchenstrahls und ein erstes Strahlführungssystem (26) zur Führung des ersten Teilchenstrahls aufweist,
- die zweite Teilchenstrahlsäule (4) mindestens einen zweiten Strahlerzeuger (34) zur Erzeugung eines zweiten Teilchenstrahls sowie mindestens ein zweites Strahlführungssystem (38) zur Führung eines zweiten Teilchenstrahls in der zweiten Teilchenstrahlsäule (4) aufweist,
- die erste Teilchenstrahlsäule (3) eine erste Objektivlinse (33) zur Fokussierung eines ersten Teilchenstrahls auf eine Probe, insbesondere eine erste Probe, aufweist und wobei die zweite Teilchenstrahlsäule (4) eine zweite Objektivlinse (38) zur Fokussierung eines zweiten Teilchenstrahls auf eine Probe, insbesondere eine zweite Probe, aufweist, und wobei
- der Detektor (9, 22) zur Detektion von Teilchen vorgesehen ist, die durch eine Probe, insbesondere eine erste Probe und/oder eine zweite Probe, transmittiert sind, und/oder die in Ausbreitungsrichtung des Teilchenstrahls aus der Probe austreten und gestreut sind.

3. Teilchenstrahlgerät (1) nach einem der vorangehenden Ansprüche, wobei das Trägerelement (5) um die erste Achse (8, 8') bis zu maximal 360°, vorzugsweise bis zu maximal 300°, bevorzugter bis zu maximal 240°, und noch bevorzugter bis zu maximal 180° drehbar ausgebildet ist.

4. Teilchenstrahlgerät (1) nach einem der vorangehenden Ansprüche, wobei das Trägerelement (5) um die zweite Achse (x) bis zu maximal 90°, vorzugsweise bis zu maximal 60°, bevorzugter bis zu maximal 45°, und noch bevorzugter bis zu maximal 30° drehbar ausgebildet ist.

5. Elektronenmikroskop, insbesondere ein Rasterelektronenmikroskop oder ein Transmissionselektronenmikroskop, das als Teilchenstrahlgerät (1) nach einem der vorangehenden Ansprüche ausgebildet ist.

6. Verfahren zur Untersuchung oder Präparation einer Probe in einem Teilchenstrahlgerät mit einer ersten Teilchenstrahlsäule (3) mit einer ersten optischen Achse (8) und mit einer zweiten Teilchenstrahlsäule (4) mit einer zweiten optischen Achse (10), wobei die erste optische Achse (8) und die zweite optische Achse (10) einen Winkel (α) einschließen, wobei
- eine erste Probe an einer ersten Aufnahmefläche eines ersten Aufnahmeelements (6) eines Trägerelements (5) in einer Vakuumkammer (2) angeordnet wird, wobei die erste Aufnahmefläche in einer ersten Ebene liegt und wobei das Trägerelement (5) in drei zueinander senkrecht angeordneten Raumrichtungen (x, y, z) beweglich ist und wobei das Trägerelement (5) um eine erste Achse (8) sowie um eine zweite Achse (x), die senkrecht zur ersten Achse angeordnet ist, drehbar ist,
- das Trägerelement (5) in mindestens eine erste Stellung bewegt wird, wobei in der ersten Stellung eine zweite Probe aus der ersten Probe extrahiert wird,
- die zweite Probe an einer zweiten Aufnahmefläche eines zweiten Aufnahmeelements (7) des Trägerelements (5) angeordnet wird, wobei die zweite Aufnahmefläche in einer zweiten Ebene liegt und wobei die erste Ebene sowie die zweite Ebene um einen Winkel (β) im Bereich von 10° bis 90° zueinander versetzt angeordnet sind, der dem Winkel (α) zwischen der ersten optischen Achse (8) und der zweiten optischen Achse (10) entspricht,
- das Trägerelement (5) in mindestens eine zweite Stellung bewegt wird, in der die zweite Probe bestrahlt wird, wobei die erste Aufnahmefläche und die zweite Aufnahmefläche derart zueinander ausgerichtet sind, dass in der ersten Stellung die erste Ebene senkrecht zur ersten optischen Achse ausgerichtet ist und dass in der zweiten Stellung die zweite Ebene senkrecht zur ersten optischen Achse ausgerichtet ist,
- durch die Bewegung des Trägerelements (5) stets das erste Aufnahmeelement (6) und das zweite Aufnahmeelement (7) in dieselbe Raumrichtung (x, y, z) und/oder um dieselbe Achse (8, 8', x) bewegt werden, wobei das erste Aufnahmeelement (6) und das zweite Aufnahmeelement (7) keine Bewegungsmechaniken aufweisen, und wobei
- Teilchen detektiert werden, wobei die Teilchen durch die zweite Probe transmittieren oder in Ausbreitungsrichtung eines Teilchenstrahls als gestreute Teilchen aus der zweiten Probe austreten und wobei die Teilchen mittels eines Detektors (9, 22) detektiert werden, der - von einem Strahlerzeuger (23, 34) in Richtung des Trägerelements (5) aus gesehen - hinter dem Trägerelement (5) angeordnet ist.

7. Verfahren nach Anspruch 6, wobei die erste Probe mittels eines ersten Teilchenstrahls (17) untersucht wird und die zweite Probe mittels eines zweiten Teilchenstrahls (18) extrahiert wird.

8. Verfahren nach Anspruch 7, wobei die zweite Probe mittels des ersten Teilchenstrahls (17) in der zweiten Stellung bestrahlt wird.

9. Verfahren nach Anspruch 7 oder 8, wobei die zweite Probe mittels des zweiten Teilchenstrahls (18) präpariert, insbesondere poliert, wird und mittels des ersten Teilchenstrahls (17) untersucht wird.

## Claims

1. Particle beam device (1) with
- a first particle beam column (3) with a first optical axis (8),
- a second particle beam column (4) with a second optical axis (10), wherein the first optical axis (8) and the second optical axis (10) form an included angle (α),
- at least one carrier element (5), which is formed movably in three spatial directions (x, y, z) arranged perpendicularly in relation to one another and which is rotatable about a first axis (8) and about a second axis (x), which is perpendicular to the first axis (8),
- at least a first receiving element (6) for receiving a first specimen and with at least a second receiving element (7) for receiving a second specimen, wherein the first receiving element (6) and the second receiving element (7) are arranged on the carrier element (5) in such a way that a movement of the carrier element (5) always causes a movement of the first receiving element (6) and the second receiving element (7) in the same spatial direction (x, y, z) and/or about the same axis (8, 8', x), wherein the first receiving element (6) and the second receiving element (7) do not have any movement mechanisms,
- wherein the carrier element (5) can be moved into at least a first position and into at least a second position, wherein, in the first position, a first specimen in the first receiving element (6) can be irradiated by means of a particle beam and wherein, in the second position, a second specimen in the second receiving element (7) can be irradiated by means of a particle beam,
wherein
- the first receiving element (6) has a first receiving surface, which lies in a first plane, and the second receiving element (7) has a second receiving surface, which lies in a second plane,
- the first plane and the second plane are arranged offset in relation to one another by an angle (β) in the range from 10° to 90°, which corresponds to the angle (α) between the first optical axis (8) and the second optical axis (10),
- the first receiving surface and the second receiving surface are aligned in relation to one another in such a way that, in a first rotational position about the second axis, the first plane is aligned perpendicularly to the first optical axis and in that, in a second rotational position about the second axis, the second plane is aligned perpendicularly to the first optical axis, and wherein
- a detector (9, 22) is arranged downstream of the carrier element (5) - in the direction of the carrier element (5) as seen from a beam generator (23, 34).

2. Particle beam device (1) according to Claim 1, wherein
- the first particle beam column (3) has the beam generator (23) in the form of a first beam generator for generating a first particle beam and a first beam guiding system (26) for guiding the first particle beam,
- the second particle beam column (4) has at least a second beam generator (34) for generating a second particle beam and at least a second beam guiding system (38) for guiding a second particle beam in the second particle beam column (4),
- the first particle beam column (3) has a first objective lens (33) for focusing a first particle beam onto a specimen, in particular a first specimen, and wherein the second particle beam column (4) has a second objective lens (38) for focusing a second particle beam onto a specimen, in particular a second specimen, and wherein
- the detector (9, 22) is provided for the detection of particles that are transmitted through a specimen, in particular a first specimen and/or a second specimen, and/or that leave the specimen in the direction of propagation of the particle beam and are scattered.

3. Particle beam device (1) according to one of the preceding claims, wherein the carrier element (5) is formed rotatably about the first axis (8, 8') up to a maximum of 360°, preferably up to a maximum of 300°, more preferably up to a maximum of 240°, and still more preferably up to a maximum of 180°.

4. Particle beam device (1) according to one of the preceding claims, wherein the carrier element (5) is formed rotatably about the second axis (x) up to a maximum of 90°, preferably up to a maximum of 60°, more preferably up to a maximum of 45°, and still more preferably up to a maximum of 30°.

5. Electron microscope, in particular a scanning electron microscope or a transmission electron microscope, which is formed as a particle beam device (1) according to one of the preceding claims.

6. Method for examining or preparing a specimen in a particle beam device with a first particle beam column (3) with a first optical axis (8) and with a second particle beam column (4) with a second optical axis (10), wherein the first optical axis (8) and the second optical axis (10) form an included angle (α), wherein
- a first specimen is arranged on a first receiving surface of the first receiving element (6) of a carrier element (5) in a vacuum chamber (2), wherein the first receiving surface lies in a first plane and wherein the carrier element (5) is movable in three spatial directions (x, y, z) arranged perpendicularly in relation to one another and wherein the carrier element (5) is rotatable about a first axis (8) and about a second axis (x), which is arranged perpendicularly to the first axis,
- the carrier element (5) is moved into at least a first position, wherein, in the first position, a second specimen is extracted from the first specimen,
- the second specimen is arranged on a second receiving surface of a second receiving element (7) of the carrier element (5), wherein the second receiving surface lies in a second plane and wherein the first plane and the second plane are arranged offset in relation to one another by an angle (β) in the range from 10° to 90°, which corresponds to the angle (α) between the first optical axis (8) and the second optical axis (10),
- the carrier element (5) is moved into at least a second position, in which the second specimen is irradiated, wherein the first receiving surface and the second receiving surface are aligned in relation to one another in such a way that, in the first position, the first plane is aligned perpendicularly to the first optical axis and in that, in the second position, the second plane is aligned perpendicularly to the first optical axis,
- the movement of the carrier element (5) always has the effect that the first receiving element (6) and the second receiving element (7) are moved in the same spatial direction (x, y, z) and/or about the same axis (8, 8', x), wherein the first receiving element (6) and the second receiving element (7) do not have any movement mechanisms, and wherein
- particles are detected, wherein the particles are transmitted through the second specimen or leave the second specimen in the direction of propagation of a particle beam as scattered particles and wherein the particles are detected by means of a detector (9, 22), which is arranged downstream of the carrier element (5) - in the direction of the carrier element (5) as seen from a beam generator (23, 34).

7. Method according to Claim 6, wherein the first specimen is examined by means of a first particle beam (17) and the second specimen is extracted by means of a second particle beam (18).

8. Method according to Claim 7, wherein the second specimen is irradiated by means of the first particle beam (17) in the second position.

9. Method according to Claim 7 or 8, wherein the second specimen is prepared, in particular polished, by means of the second particle beam (18) and is examined by means of the first particle beam (17).

## Revendications

1. Appareil de faisceau de particules chargées (1) avec
- une première colonne de faisceau de particules chargées (3) avec un premier axe optique (8),
- une deuxième colonne de faisceau de particules chargées (4) avec un deuxième axe optique (10), le premier axe optique (8) et le deuxième axe optique (10) comprenant un angle (α),
- au moins un élément de support (5), qui est constitué de manière mobile en trois directions spatiales (x, y, z) disposées perpendiculairement l'une par rapport à l'autre et qui peut tourner autour d'un premier axe (8) ainsi qu'autour d'un deuxième axe (x), qui est disposé perpendiculairement au premier axe (8),
- au moins un premier élément de réception (6) pour loger un premier échantillon et avec au moins un deuxième élément de réception (7) pour loger un deuxième échantillon, le premier élément de réception (6) et le deuxième élément de réception (7) étant disposés sur l'élément de support (5) de telle manière qu'un déplacement de l'élément de support (5) conditionne toujours un déplacement du premier élément de réception (6) et du deuxième élément de réception (7) dans la même direction spatiale (x, y, z) et/ou autour du même axe (8, 8', x), le premier élément de réception (6) et le deuxième élément de réception (7) ne comportant aucun mécanisme de déplacement,
- l'élément de support (5) étant mobile dans au moins une première position et au moins une deuxième position, dans la première position, un premier échantillon pouvant être irradié dans le premier élément de réception (6) au moyen d'un faisceau de particules chargées et dans la deuxième position, un deuxième échantillon pouvant être irradié dans le deuxième élément de réception (7) au moyen d'un faisceau de particules chargées,
- le premier élément de réception (6) comportant une première surface de réception, laquelle se trouve dans un premier plan, et le deuxième élément de réception (7) comportant une deuxième surface de réception, laquelle se trouve dans un deuxième plan,
- le premier plan et le deuxième plan étant disposés décalés l'un par rapport à l'autre d'un angle (β) dans une plage de 10° à 90°, qui correspond à l'angle (α) entre le premier axe optique (8) et le deuxième axe optique (10),
- la première surface de réception et la deuxième surface de réception étant orientées l'une par rapport à l'autre de telle manière que dans une première position de rotation autour du deuxième axe, le premier plan est orienté perpendiculairement au premier axe optique et que dans une deuxième position de rotation autour du deuxième axe, le deuxième plan est orienté perpendiculairement au premier axe optique, et
- un détecteur (9, 22), vu d'un générateur de faisceau (23, 24) en direction de l'élément de support (5), étant disposé derrière l'élément de support (5).

2. Appareil de faisceau de particules chargées (1) selon la revendication 1,
- la première colonne de faisceau de particules chargées (3) comportant le générateur de faisceau (23) sous la forme d'un premier générateur de faisceau pour produire un premier faisceau de particules chargées et un premier système de guidage de faisceau (26) pour guider le premier faisceau de particules chargées,
- la deuxième colonne de faisceau de particules chargées (4) comportant au moins un deuxième générateur de faisceau (34) pour produire un deuxième faisceau de particules chargées ainsi qu'au moins un deuxième système de guidage de faisceau (38) pour guider le deuxième faisceau de particules chargées dans la deuxième colonne de faisceau de particules chargées (4),
- la première colonne de faisceau de particules chargées (3) comportant une première lentille d'objectif (33) pour concentrer un premier faisceau de particules chargées sur un échantillon, en particulier un premier échantillon, et la deuxième colonne de faisceau de particules chargées (4) comportant une deuxième lentille d'objectif (38) pour concentrer un deuxième faisceau de particules chargées sur un échantillon, en particulier un deuxième échantillon, et
- le détecteur (9, 22) étant prévu pour la détection des particules qui sont transmises par un échantillon, en particulier un premier échantillon et/ou un deuxième échantillon, et/ou qui sortent de l'échantillon et sont dispersées dans la direction d'expansion du faisceau de particules chargées.

3. Appareil de faisceau de particules chargées (1) selon l'une quelconque des revendications précédentes, l'élément de support (5) étant constitué de façon à pouvoir tourner autour du premier axe (8, 8') jusqu'à un maximum de 360°, de préférence jusqu'à un maximum de 300°, de façon préférée jusqu'à un maximum de 240° et de manière encore plus préférée jusqu'à un maximum de 180°.

4. Appareil de faisceau de particules chargées (1) selon l'une quelconque des revendications précédentes, l'élément de support (5) étant constitué de façon à pouvoir tourner autour du deuxième axe (x) jusqu'à un maximum de 90°, de préférence jusqu'à un maximum de 60°, de façon préférée jusqu'à un maximum de 45° et de manière encore plus préférée jusqu'à un maximum de 30°.

5. Microscope électronique, en particulier microscope électronique à balayage ou microscope électronique à transmission, qui est constitué comme appareil à faisceau de particules chargées (1) selon l'une quelconque des revendications précédentes.

6. Procédé destiné à l'analyse ou la préparation d'un échantillon dans un appareil à faisceau de particules chargées avec une première colonne de faisceau à particules chargées (3) avec un premier axe optique (8) et avec une deuxième colonne de faisceau de particules chargées (4) avec un deuxième axe optique (10), le premier axe optique (8) et le deuxième axe optique (10) comprenant un angle (α),
- un premier échantillon étant disposé sur une première surface de réception d'un premier élément de réception (6) d'un élément de support (5) dans une chambre de vide (2), la première surface de réception se trouvant dans un premier plan et l'élément de support (5) étant mobile dans trois directions spatiales (x, y, z) disposées perpendiculairement l'une par rapport par rapport à l'autre et l'élément de support (5) pouvant tourner autour d'un premier axe (8) ainsi qu'autour d'un deuxième axe (x), qui est disposé perpendiculairement au premier axe,
- l'élément de support (5) étant déplacé dans au moins une première position, un deuxième échantillon étant extrait du premier échantillon dans la première position,
- le deuxième échantillon étant disposé sur une deuxième surface de réception d'un deuxième élément de réception (7) de l'élément de support (5), la deuxième surface de réception se trouvant dans un deuxième plan et le premier plan ainsi que le deuxième plan étant disposés décalés l'un par rapport à l'autre d'un angle (β) dans une plage de 10° à 90°, qui correspond à l'angle (α) entre le premier axe optique (8) et le deuxième axe optique (10),
- l'élément de support (5) étant déplacé dans au moins une deuxième position dans laquelle le deuxième échantillon est irradié, la première surface de réception et la deuxième surface de réception étant orientées l'une par rapport à l'autre de telle manière que dans la première position, le premier plan est orienté perpendiculairement au premier axe optique et que dans la deuxième position, le deuxième plan est orienté perpendiculairement au premier axe optique,
- le premier élément de réception (6) et le deuxième élément de réception (7) étant toujours déplacés par le déplacement de l'élément de support (5) dans la même direction spatiale (x, y, z) et/ou autour du même axe (8, 8', x), le premier élément de réception (6) et le deuxième élément de réception (7) ne comportant aucun mécanisme de déplacement, et
- des particules chargées étant détectées, les particules chargées étant transmises par le deuxième échantillon ou sortant du deuxième échantillon dans la direction d'expansion d'un faisceau de particules chargées en tant que particules chargées dispersées et les particules chargées étant détectées au moyen d'un détecteur (9, 22), qui est disposé, vu d'un générateur de faisceau (23, 34) en direction de l'élément de support (5), derrière l'élément de support (5).

7. Procédé selon la revendication 6, le premier échantillon étant analysé au moyen d'un premier faisceau de particules chargées (17) et le deuxième échantillon étant extrait au moyen d'un deuxième faisceau de particules chargées (18).

8. Procédé selon la revendication 7, le deuxième échantillon étant irradié dans la deuxième position au moyen du premier faisceau de particules chargées (17).

9. Procédé selon la revendication 7 ou 8, le deuxième échantillon étant préparé au moyen du deuxième faisceau de particules chargées (18), en particulier poli, et analysé au moyen du premier faisceau de particules chargées (17).
